# EUROPEAN PATENT APPLICATION

(11) **EP 4 597 572 A1**
(43) Date of publication of application: **06.08.2025**
(21) Application number: 23873297.8
(22) Date of filing: 04.10.2023
(51) Int. Cl.: H01L 25/065, H01L 25/18, H01L 23/538

(54) **CIRCUIT BOARD AND SEMICONDUCTOR PACKAGE INCLUDING SAME**

(30) Priority: 29.09.2022 KR 20220124719
(71) Applicant: LG INNOTEK CO. LTD, Gangseo-gu Seoul 07796 (KR)
(72) Inventor: SON, Yong Ho, Seoul 07796 (KR); KIM, Moo Seong, Seoul 07796 (KR)
(74) Representative: Plasseraud IP
(86) International application number: PCT/KR2023/015251
(87) International publication number: WO 2024/072190

(57) **Abstract**

A circuit board according to an embodiment includes an insulating layer; a connection member embedded in the insulating layer; and an electrode part embedded in the insulating layer and overlapping the connection member in a vertical direction, wherein the connection member includes an electrode pattern disposed on the connection member, and the electrode pattern is electrically floated with the electrode part.

## Description

### [Technical Field]

An embodiment relates to a semiconductor package, and more particularly, to a semiconductor package having improved bonding strength between an insulating substrate and a connection member.

### [Background Art]

As performances of electric/electronic products progresses, technologies for disposing a greater number of semiconductor devices on a semiconductor package substrate of a limited size are being proposed and studied. However, since a general semiconductor package is based on mounting a single semiconductor device, there is a limit to obtaining a desired performance.

Accordingly, a semiconductor package that mounts a plurality of semiconductor devices using a plurality of circuit boards has been recently provided. This semiconductor package has a structure in which a plurality of semiconductor devices are connected to each other in a horizontal direction and/or a vertical direction on the circuit board. Accordingly, the semiconductor package has the advantage of efficiently using a mounting area of the semiconductor devices and transmitting highspeed signals through a short signal transmission path between the semiconductor devices.

Due to these advantages, the semiconductor package as described above is widely applied to mobile devices, etc.

In addition, semiconductor packages applied to products that provide the Internet of Things (IoT), autonomous vehicles, and high-performance servers are expanding a concept to semiconductor chiplets as a number of semiconductor devices and/or a size of each semiconductor device increases in accordance with a trend of high integration, or as functional parts of the semiconductor devices are divided.

Accordingly, an intercommunication between semiconductor devices and/or semiconductor chiplets is becoming important, and accordingly, there is a trend to dispose an interposer between the circuit board of the semiconductor package and the semiconductor devices.

An interposer can function as a redistribution layer that gradually increases a width or depth of a circuit pattern from the semiconductor device to the semiconductor package in order to facilitate the intercommunication between the semiconductor devices and/or semiconductor chiplets, or to interconnect the semiconductor devices and the semiconductor package circuit board, thereby smoothly transmitting electrical signals between the semiconductor device and the semiconductor package circuit board having a relatively large circuit pattern compared to the circuit pattern of the semiconductor device.

Meanwhile, a package circuit board and/or interposer applied to a semiconductor package is provided with a connection member connected to a semiconductor device and/or a semiconductor chip-let. The connection member functions to horizontally connect a plurality of semiconductor devices and/or semiconductor chip-lets. Accordingly, the connection member may be embedded in the package circuit board and/or interposer.

At this time, the connection member may be either an inorganic bridge or an organic bridge. In addition, electrodes provided in the connection member may have a smaller width and/or spacing than electrodes provided in the package substrate and/or the interposer. For example, the connection member includes high-density electrodes. Therefore, a surface roughness of the electrodes provided in the connection member may have a relatively small value. That is, as the surface roughness of the electrodes increases, it may be difficult to refine a line width or spacing of the electrodes. Therefore, if the connection member is embedded in the package substrate and/or the interposer, the adhesion between the connection member and the package substrate and/or the interposer may be reduced. Accordingly, a problem of the connection member being peeled off from the package substrate and/or the interposer may occur.

### [Disclosure]

### [Technical Problem]

An embodiment provides a semiconductor package having a novel structure.

In addition, the embodiment provides a semiconductor package including a substrate and a connection member embedded in the substrate.

In addition, the embodiment provides a semiconductor package having improved mechanical reliability and electrical reliability.

In addition, the embodiment provides a semiconductor package capable of improving adhesion between the substrate and the connection member.

In addition, the embodiment provides a semiconductor package capable of preventing the substrate and/or the connection member from being greatly bent in a specific direction.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises an insulating layer; a connection member embedded in the insulating layer; and an electrode part embedded in the insulating layer and overlapping the connection member in a vertical direction, wherein the connection member includes an electrode pattern disposed on the connection member, and wherein the electrode pattern is electrically floated with the electrode part.

In addition, the connection member includes first and second connection electrodes spaced apart from the electrode pattern in a horizontal direction, the electrode part includes a first electrode part overlapping the first connection electrode in the vertical direction; and a second electrode part overlapping the second connection electrode in the vertical direction; and the electrode pattern is electrically floated with the first electrode part, the second electrode part, the first connection electrode, and the second connection electrode.

In addition, the insulating layer includes a first insulating layer having a cavity; and a second insulating layer disposed on the first insulating layer and filling at least a portion of the cavity, and the connection member is disposed in the cavity, the first electrode part includes a first through electrode penetrating at least a portion of the second insulating layer and overlapping the first connection electrode in the vertical direction and a second through electrode penetrating at least a portion of the second insulating layer and overlapping the first connection electrode in the vertical direction, and the electrode pattern does not overlap the first and second through electrodes in the vertical direction.

In addition, the first electrode part includes a first wiring electrode disposed on the first through electrode and a second wiring electrode disposed on the second through electrode, and the electrode pattern does not overlap the first and second wiring electrodes in the vertical direction.

In addition, the electrode pattern is disposed on an upper surface of the connection member in a same plane as the first and second connection electrodes.

In addition, a surface roughness value of the electrode pattern is greater than a surface roughness value of at least one of the first and second connection electrodes.

In addition, each of the first and second connection electrodes is provided in a plurality of numbers, and a plane area of an single electrode pattern is greater than a plane area of a single electrode of each of the plurality of first and second connection electrodes.

In addition, edge shapes of upper surfaces of each of the first and second connection electrodes are identical to each other, and an edge shape of an upper surface of the electrode pattern is different from the edge shapes of the first and second connection electrodes.

In addition, the circuit board further comprises a dummy through electrode disposed on the electrode pattern and overlapping at least a portion of the first and second through electrodes in a horizontal direction, and a dummy wiring electrode disposed on the dummy through electrode and overlapping the first and second wiring electrodes in the horizontal direction.

In addition, the circuit board further comprises a protective layer disposed on the insulating layer; and a first protruding electrode penetrating at least a portion of the protective layer and overlapping the first wiring electrode in the vertical direction; a second protruding electrode penetrating at least a portion of the protective layer and overlapping the second wiring electrode in the vertical direction; and a dummy protruding electrode penetrating at least a portion of the protective layer and overlapping the dummy wiring electrode in the vertical direction.

Meanwhile, a semiconductor package according to an embodiment includes the circuit board and a semiconductor device disposed on the circuit board, the semiconductor device includes first and second semiconductor devices spaced apart on the circuit board along a horizontal direction, and the electrode pattern overlaps a separation region between the first and second semiconductor devices in the vertical direction.

In addition, the first semiconductor device includes first terminals overlapping the first connection electrode in the vertical direction, and the second semiconductor device includes second terminals overlapping the second connection electrode in the vertical direction.

In addition, at least a part of the electrode pattern does not vertically overlap with the first and second semiconductor devices.

In addition, the electrode pattern is electrically floated with the first and second terminals of the first and second semiconductor devices.

In addition, a lower surface of each of the first and second through electrodes is positioned lower than an upper surface of the connection member, and the electrode pattern is disposed on an upper surface of the connection member to overlap with the first and second through electrodes in a horizontal direction.

In addition, each of the first and second connection electrodes is provided in a plurality of numbers, and each of the plurality of first and second connection electrodes is spaced apart from each other with a dummy region interposed therebetween on the connection member, and the electrode pattern is disposed in the dummy region of the connection member.

In addition, a width of the dummy region in the horizontal direction satisfies a range of 160 µm to 310 µm.

In addition, a first terminal disposed closest to an edge of one surface of the first semiconductor device among the plurality of first terminals is spaced apart from the edge of the one surface of the first semiconductor device by a range of 40 µm to 80 µm, and a second terminal disposed closest to an edge of one surface of the second semiconductor device among the plurality of second terminals is spaced apart from the edge of the one surface of the second semiconductor device by a range of 40 µm to 80 µm.

In addition, the first semiconductor device and the second semiconductor device include side parts facing each other horizontally, and a horizontal distance between the side parts satisfies a range of 80 µm to 150 µm.

In addition, a horizontal distance between first and second terminals disposed closest to each other among the plurality of first terminals and the plurality of second terminals satisfies a range of 160 µm to 310 µm.

In addition, the semiconductor package further comprises a third semiconductor device disposed on the circuit board and vertically overlapping at least a portion of the connection member, and the electrode pattern includes first dummy electrode patterns vertically overlapping with a separation region between the first and second semiconductor devices, and second dummy electrode patterns disposed in a region vertically overlapping with a separation region between the first or second semiconductor and the third semiconductor device.

### [Advantageous Effects]

The semiconductor package of the embodiment may include an insulating layer and a connection member embedded in the insulating layer. The connection member may include first and second connection electrodes. In addition, the semiconductor package may include a first electrode part and a second electrode part disposed in the insulating layer. The first electrode part may vertically overlap with a first connection electrode of the connection member. In addition, the second electrode part may vertically overlap with a second connection electrode of the connection member. In addition, the electrode part may further include a third electrode part provided between the first electrode part and the second electrode part or between the first connection electrode and the second connection electrode. The third electrode part may be electrically floated with the connection member and may physically contact the connection member. The third electrode part may be provided in a region of an upper surface of the connection member where the connection electrode is not provided. The third electrode part may improve adhesion between the insulating layer and the connection member.

Through this, the embodiment can increase an adhesion between the insulating layer and the connection member, thereby solving a problem of the connection member being peeled off from the insulating layer.

Furthermore, the embodiment can improve a rigidity of the connection member and/or a rigidity of the semiconductor package by using the third electrode part, thereby improving the mechanical reliability of the semiconductor package. Through this, the embodiment can solve a problem of the connection member and/or the semiconductor package being greatly bent in a specific direction. Through this, the embodiment can enable the semiconductor package to operate stably. In addition, the embodiment can enable an electronic product and/or server to which the semiconductor package is applied to operate smoothly.

In addition, a surface roughness value of the third electrode part can be greater than a surface roughness value of the connection electrode provided in the connection member. Through this, the embodiment can minimize a signal transmission loss that increases in proportion to the surface roughness value by making the connection electrode have a surface roughness value smaller than the surface roughness value of the third electrode part, thereby improving signal transmission characteristics of the semiconductor package. Furthermore, the embodiment can further improve the adhesion between the insulating layer and the connection member without affecting the signal transmission characteristics by increasing the surface roughness value of a dummy electrode.

Meanwhile, the dummy electrode in one embodiment can include only a dummy electrode pattern disposed on the connection member. The dummy electrode in another embodiment can include a dummy through electrode penetrating from an upper surface of the first insulating layer to a portion of the first insulating layer, together with the dummy electrode pattern. In another embodiment, the third electrode part can include a dummy through electrode and a dummy protruding electrode together with the dummy electrode pattern. In addition, when the third electrode part includes the dummy through electrode and the dummy protruding electrode, an adhesion between the connection member and the insulating layer can be further improved, while further improving the rigidity of the semiconductor package.

### [Description of Drawings]

FIG. 1a is a cross-sectional view showing a semiconductor package according to a first embodiment.
FIG. 1b is a cross-sectional view showing a semiconductor package according to a second embodiment.
FIG. 1c is a cross-sectional view showing a semiconductor package according to a third embodiment.
FIG. 1d is a cross-sectional view showing a semiconductor package according to a fourth embodiment.
FIG. 1e is a cross-sectional view showing a semiconductor package according to a fifth embodiment.
FIG. 2 is a cross-sectional view showing a circuit board according to a first embodiment.
FIG. 3 is a plan view of the circuit board of FIG. 2 viewed from an upward direction.
FIG. 4 is a cross-sectional view of a semiconductor package including a circuit board of FIG. 2.
FIG. 5 is an enlarged view of a partial region of FIG. 4.
FIG. 6 is a plan view of a connection member embedded in the circuit board of FIG. 2 viewed from an upward direction.
FIG. 7 is a plan view of a connection member including a dummy electrode disposed on a connection member according to the first embodiment.
FIG. 8 is a cross-sectional view showing a surface roughness of the connection electrode and the dummy electrode of FIG. 7.
FIG. 9 is a plan view of a connection member including a dummy electrode disposed in a connection member according to a second embodiment.
FIG. 10 is a plan view of a connection member including a dummy electrode disposed in a connection member according to a third embodiment.
FIG. 11 is a plan view of a connection member including a dummy electrode disposed in a connection member according to a fourth embodiment.
FIG. 12 is a drawing showing a detailed layer structure of a connection member according to one embodiment.
FIG. 13 is a cross-sectional view showing a detailed layer structure of a protruding electrode included in the circuit board of FIG. 2.
FIG. 14 is a cross-sectional view showing a circuit board according to a second embodiment.
FIG. 15 is a cross-sectional view showing a circuit board according to a third embodiment.
FIG. 16 is a cross-sectional view showing a circuit board according to a fourth embodiment.

### [Best Mode]

Hereinafter, exemplary embodiments of the present invention will be described in detail with reference to the accompanying drawings, wherein like reference numerals are used to designate identical or similar elements, and redundant description thereof will be omitted. The suffix "module" and "portion" of the components used in the following description are only given or mixed in consideration of ease of preparation of the description, and there is no meaning or role to be distinguished as it is from one another. Also, in the following description of the embodiments of the present invention, a detailed description of related arts will be omitted when it is determined that the gist of the embodiments disclosed herein may be obscured. Also, the accompanying drawings are included to provide a further understanding of the invention, are incorporated in, and constitute a part of this description, and it should be understood that the invention is intended to cover all modifications, equivalents, or alternatives falling within the spirit and scope of the invention.

Terms including ordinals, such as first, second, etc., may be used to describe various components, but the elements are not limited to these terms. The terms are used only for distinguishing one component from another.

When a component is referred to as being "connected" or "contacted" to another component, it may be directly connected or joined to the other component, but it should be understood that other component may be present therebetween. When a component is referred to as being "directly connected" or "directly contacted" to another component, it should be understood that other component may not be present therebetween.

A singular representation includes plural representations, unless the context clearly implies otherwise.

In the present application, terms such as "including" or "having" are used to specify the presence of features, numbers, steps, operations, components, parts, or combinations thereof described in the description. However, it should be understood that the terms do not preclude the presence or addition of one or more other features, numbers, steps, operations, components, parts, or combinations thereof.

Hereinafter, embodiments of a present invention will be described in detail with reference to attached drawings.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one semiconductor device. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (e.g., DRAM), non-volatile memory (e.g., ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later.

In addition, the circuit board in one embodiment may be a first circuit board described below.

Alternatively, the circuit board in another embodiment may be a second circuit board described below.

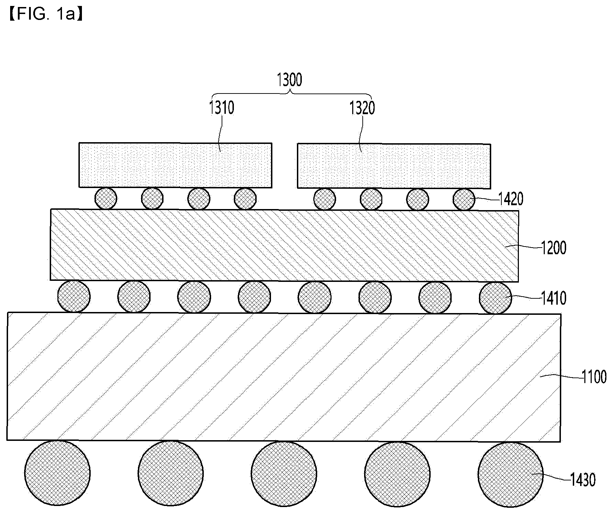

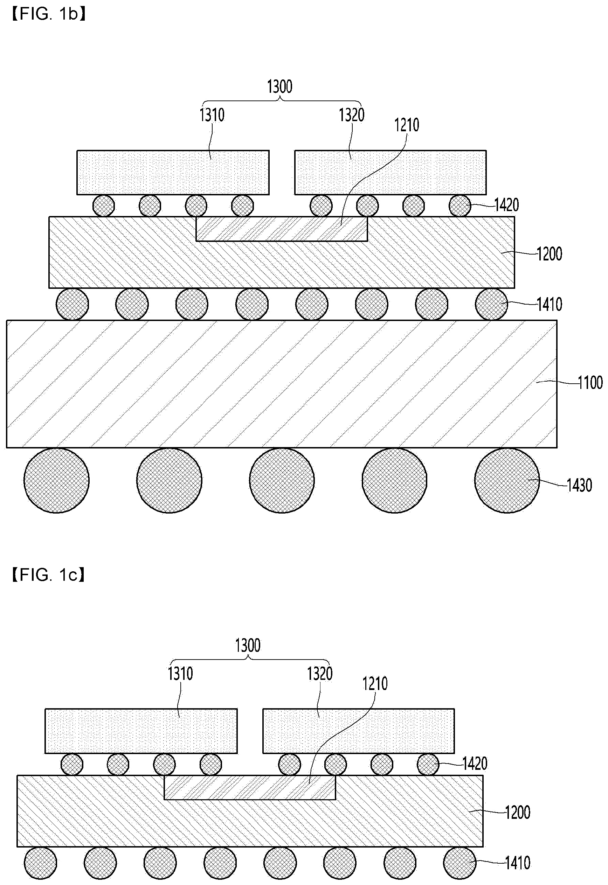

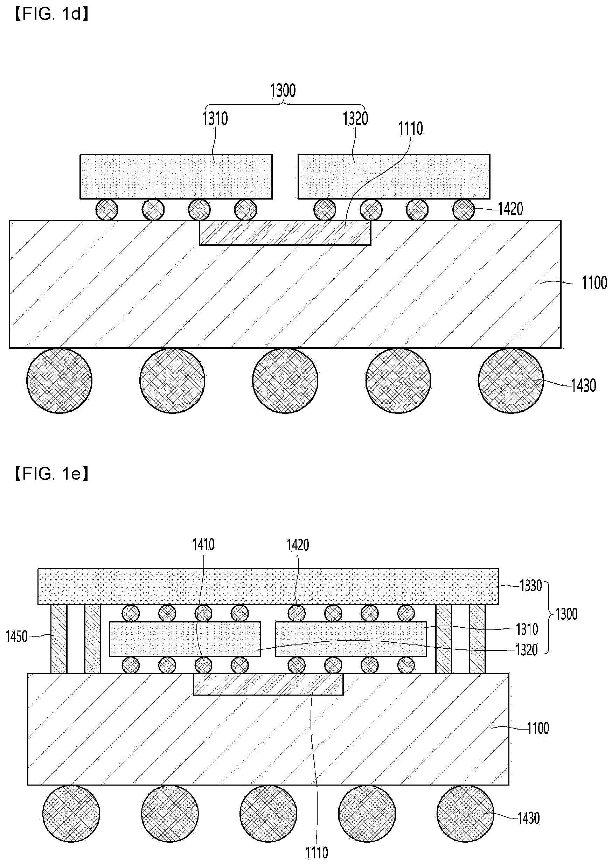

FIG. 1a is a cross-sectional view showing a semiconductor package according to a first embodiment, FIG. 1b is a cross-sectional view showing a semiconductor package according to a second embodiment, FIG. 1c is a cross-sectional view showing a semiconductor package according to a third embodiment, FIG. 1d is a cross-sectional view showing a semiconductor package according to a fourth embodiment, and FIG. 1e is a cross-sectional view showing a semiconductor package according to a fifth embodiment.

Referring to FIG. 1a, the semiconductor package according to the first embodiment may include a first circuit board 1100, a second circuit board 1200, and a semiconductor device 1300.

The first circuit board 1100 may mean a package circuit board.

For example, the first circuit board 1100 may provide a space to which at least one external circuit board is coupled. The external circuit board may refer to a second circuit board 1200 coupled to the first circuit board 1100. Also, the external circuit board may refer to a main board included in an electronic device coupled to a lower portion of the first circuit board 1100.

Also, although not shown in the drawing, the first circuit board 1100 may provide a space in which at least one semiconductor device is mounted.

The first circuit board 1100 may include at least one insulating layer, an electrode part disposed on the at least one insulating layer.

A second circuit board 1200 may be disposed on the first circuit board 1100.

The second circuit board 1200 may be an interposer. For example, the second circuit board 1200 may provide a space in which at least one semiconductor device is mounted. The second circuit board 1200 may be connected to the at least one semiconductor device 1300. For example, the second circuit board 1200 may provide a space in which the first semiconductor device 1310 and the second semiconductor device 1320 are mounted. The second circuit board 1200 may electrically connect the first and second semiconductor devices 1310 and 1320 and the first circuit board 1100 while electrically connecting the first semiconductor device 1310 and the second semiconductor device 1320. That is, the second circuit board 1200 may perform a horizontal connection function between a plurality of semiconductor devices and a vertical connection function between the semiconductor devices and the package circuit board.

FIG. 1a illustrates that the first and second semiconductor devices 1310 and 1320 are disposed on the second circuit board 1200, but is not limited thereto. For example, one semiconductor device may be disposed on the second circuit board 1200, or alternatively, three or more semiconductor devices may be disposed.

The second circuit board 1200 may be disposed between at least one semiconductor device 1300 and the first circuit board 1100.

In an embodiment, the second circuit board 1200 may be an active interposer that functions as a semiconductor device. When the second circuit board 1200 functions as a semiconductor device, the semiconductor package of the embodiment may have a structure that is vertically stacked on the first circuit board 1100 and may have functions of multiple logic chips. Having the function of a logic chip may mean that it may have functions of an active device and a passive device. In a case of an active device, characteristics of current and voltage may not be linear unlike a passive device, and in a case of an active interposer, it may have the function of an active device. In addition, the active interposer may perform a function of a corresponding logic chip while performing a signal transmission function between a second logic chip disposed thereon and the first circuit board 1100.

According to another embodiment, the second circuit board 1200 may be a passive interposer. For example, the second circuit board 1200 may function as a signal relay between the semiconductor device 1300 and the first circuit board 1100, and can have a passive device function such as a resistor, capacitor, or inductor. For example, a number of terminals of the semiconductor device 1300 is gradually increasing due to 5G, Internet of Things (IOT), increased image quality, and increased communication speed. That is, the number of terminals provided in the semiconductor device 1300 increases, thereby reducing the width of the terminals or an interval between the plurality of terminals. In this case, the first circuit board 1100 may be connected to the main board of the electronic device. There is a problem in that the thickness of the first circuit board 1100 increases or the layer structure of the first circuit board 1100 becomes complicated in order for the electrodes provided on the first circuit board 1100 to have a width and an interval to be respectively connected to the semiconductor device 1300 and the main board. Accordingly, in the first embodiment, the second circuit board 1200 may be disposed on the first circuit board 1100 and the semiconductor device 1300. In addition, the second circuit board 1200 may include electrodes having a fine width and an interval corresponding to the terminals of the semiconductor device 1300.

The semiconductor device 1300 may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far. The memory chip may be a stack memory such as HBM. The memory chip may also include a memory chip such as volatile memory (e.g., DRAM), non-volatile memory (e.g., ROM), flash memory, and the like.

Meanwhile, the semiconductor package of the first embodiment may include a connection part.

For example, the semiconductor package may include a first connection part 1410 disposed between the first circuit board 1100 and the second circuit board 1200. The first connection part 1410 may electrically connect the second circuit board 1200 to the first circuit board 1100 while coupling them.

For example, the semiconductor package may include the second connection part 1420 disposed between the second circuit board 1200 and the semiconductor device 1300. The second connection part 1420 may electrically connect the semiconductor device 1300 to the second circuit board 1200 while coupling them.

The semiconductor package may include a third connection part 1430 disposed on a lower surface of the first circuit board 1100. The third connection part 1430 may electrically connect the first circuit board 1100 to the main board while coupling them.

At this time, the first connection part 1410, the second connection part 1420, and the third connection part 1430 may electrically connect between the plurality of components by using at least one bonding method of wire bonding, solder bonding and metal-to-metal direct bonding. That is, since the first connection part 1410, the second connection part 1420, and the third connection part 1430 have a function of electrically connecting a plurality of components, when the metal-to-metal direct bonding is used, the connection part of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. In addition, to directly bond between the plurality of components. In addition, the metal-to-metal direct bonding method may refer to a bonding method by the second connection part 1420. In this case, the second connection part 1420 may mean a metal layer formed between a plurality of components by the recrystallization.

Specifically, the first connection part 1410, the second connection part 1420, and the third connection part 1430 may couple a plurality of components to each other by a thermal compression (TC) bonding method. The thermal compression bonding may refer to a method of directly coupling a plurality of components by applying heat and pressure to the first connection part 1410, the second connection part 1420, and the third connection part 1430.

At this time, at least one of the first circuit board 1100 and the second circuit board 1200 may be provided with a protrusion that protrudes outwardly away from the insulating layer of the corresponding board, on which the first connection part 1410, the second connection part 1420, and the third connection part 1430 are disposed. The protrusion may protrude outwardly from the first circuit board 1100 or the second circuit board 1200.

The protrusion may be a bump. The protrusion may be a post. The protrusion may be referred a pillar. Preferably, the protrusion may refer to an electrode on which a second connection part 1420 for coupling with the semiconductor device 1300 is disposed among the electrodes of the second circuit board 1200. That is, as the pitch of the terminals of the semiconductor device 1300 becomes finer, a short circuit may occur between the plurality of second connection parts 1420 that are respectively connected to the plurality of terminals of the semiconductor device 1300 by a conductive adhesive such as a solder. Therefore, in the embodiment, thermal compression bonding may be performed to reduce a volume of the second connection part 1420. In addition, in order to secure diffusion prevention and alignment to prevent an intermetallic compound (IMC) formed between a conductive adhesive such as solder and a protrusion from diffusing into the interposer and/or the circuit board, a protrusion may be included in the electrode of the second circuit board 1200 on which the second connection part 1420 is disposed.

In addition, the semiconductor package may include a connection member 1210.

The connection member may be referred to as a bridge circuit board. For example, the connection member 1210 may include a redistribution layer. The connection member 1210 may perform a function of electrically connecting a plurality of semiconductor devices horizontally to each other. For example, since the area that a semiconductor device should generally have been too large, the connection member 1210 may include a redistribution layer. Since the semiconductor package and the semiconductor device have a large difference in a width or spacing of the circuit pattern, etc., a buffering role of the circuit pattern for electrical connection is required. The buffering role may mean having a size between a width or spacing of the circuit pattern of the semiconductor package and a width or spacing of the circuit pattern of the semiconductor device, and the redistribution layer may include a function of performing the buffering role.

In one embodiment, the connection member 1210 may be an inorganic bridge. As an example, the inorganic bridge may include a silicon bridge. That is, the connection member 1210 may include a silicon circuit board and a redistribution layer disposed on the silicon circuit board.

In another embodiment, the connection member 1210 may be an organic material bridge. For example, the connection member 1210 may include an organic material. For example, the connection member 1210 may include an organic circuit board including an organic material instead of the silicon circuit board. The connection member 1210 may be embedded in the second circuit board 1200.

For this purpose, the second circuit board 1200 may include a cavity, and the connection member 1210 may be disposed in the cavity of the second circuit board 1200. The connection member 1210 may horizontally connect a plurality of semiconductor devices disposed on the second circuit board 1200.

Referring to FIG. 1b, the semiconductor package according to the second embodiment may include a second circuit board 1200 and a semiconductor device 1300. In this case, the semiconductor package of the second embodiment may have a structure in which the first circuit board 1100 is removed compared to the semiconductor package of the first embodiment.

That is, the second circuit board 1200 of the second embodiment may function as a package circuit board while performing an interposer function.

The first connection part 1410 disposed on the lower surface of the second circuit board 1200 may couple the second circuit board 1200 to the main board of the electronic device.

Referring to FIG. 1c, the semiconductor package according to the third embodiment may include a first circuit board 1100 and a semiconductor device 1300.

In this case, the semiconductor package of the third embodiment may have a structure in which the second circuit board 1200 is omitted compared to the semiconductor package of the first embodiment.

That is, the first circuit board 1100 of the third embodiment can function as a package circuit board while also performing the function of connecting the semiconductor device 1300 and a main board. To this end, the first circuit board 1100 may include a connection member 1110 for connecting the plurality of semiconductor devices. The connection member 1110 may be an inorganic bridge or an organic material bridge connecting a plurality of semiconductor devices.

Referring to FIG. 1d, the semiconductor package of the fourth embodiment further may include a third semiconductor device 1330 compared to the semiconductor package of the third embodiment.

To this end, a fourth connection part 1440 may be disposed on the lower surface of the first circuit board 1100.

A third semiconductor device 1330 may be disposed on the fourth connection part1400. That is, the semiconductor package of the fourth embodiment may have a structure in which semiconductor devices are mounted on upper and lower sides, respectively.

In this case, the third semiconductor device 1330 may have a structure disposed on the lower surface of the second circuit board 1200 in the semiconductor package of FIG. 1b.

Referring to FIG. 1e, the semiconductor package according to a sixth embodiment may include a first circuit board 1100. A first semiconductor device 1310 and a second semiconductor device 1320 may be disposed on the first circuit board 1100. To this end, a first connection part 1410 may be disposed between the first circuit board 1100 and the first semiconductor device 1310 the second semiconductor device 1320.

A connection member 1110 can be embedded in the first circuit board 1110. The connection member 1110 can horizontally connect the first and second semiconductor devices 1310 and 1320.

In addition, the first circuit board 1100 may include a conductive coupling portion 1450. The conductive coupling portion 1450 may further protrude from the first circuit board 1100 toward the second semiconductor device 1320. The conductive coupling portion 1450 may be referred to as a bump or, alternatively, may also be referred to as a post. The conductive coupling portion 1450 may be disposed to have a protruding structure on an electrode disposed on an uppermost side of the first circuit board 1100.

A third semiconductor device 1330 may be disposed on the conductive coupling portion 1450. In this case, the third semiconductor device 1330 may be connected to the first circuit board 1100 through the conductive coupling portion 1450. In addition, a second connection part 1420 may be disposed between the first semiconductor device 1310 and the second semiconductor device 1320 and the third semiconductor device 1330.

Accordingly, the third semiconductor device 1330 may be electrically connected to the first semiconductor device 1310 through the second connection part 1420.

That is, the third semiconductor device 1330 may be connected to the first circuit board 1100 through the conductive coupling portion 1450, and may be also connected to the first and second semiconductor devices 1310 and 1320 through the second connection part 1420.

In this case, the third semiconductor device 1330 may receive a power signal and/or electric power through the conductive coupling portion 1450. In addition, the third semiconductor device 1330 can exchange communication signals with the first and second semiconductor devices 1310 and 1320 through the second connection part 1420.

The semiconductor package according to the fifth embodiment may provide a power signal and/or electric power to the third semiconductor device 1330 through the conductive coupling portion 1450, thereby providing sufficient power for driving the third semiconductor device 1330 or enabling smooth control of a power operation.

Accordingly, the embodiment may improve the driving characteristics of the third semiconductor device 1330. That is, the embodiment may solve a problem of insufficient power provided to the third semiconductor device 1330. Furthermore, in the embodiment, at least one of a power signal, an electric power, and a communication signal of the third semiconductor device 1330 may be provided through different paths through the conductive coupling portion 1450 and the second connection part 1420. Through this, the embodiment can solve the problem that the communication signal is lost due to the power signal. For example, the embodiment may minimize mutual interference between communication signals of power signals.

Meanwhile, the second semiconductor device 1320 in the fifth embodiment may have a POP (Package On Package) structure in which a plurality of package circuit boards are stacked and may be disposed on the first circuit board 1100. For example, the third semiconductor device 1330 may be a memory package including a memory chip. In addition, the memory package may be coupled on the conductive coupling portion 1450. In this case, the memory package may not be connected to the first and second semiconductor devices 1310 and 1320.

Hereinafter, a circuit board of an embodiment will be described. The circuit board described below may be either a first circuit board 1100 or a second circuit board 1200 of a semiconductor package.

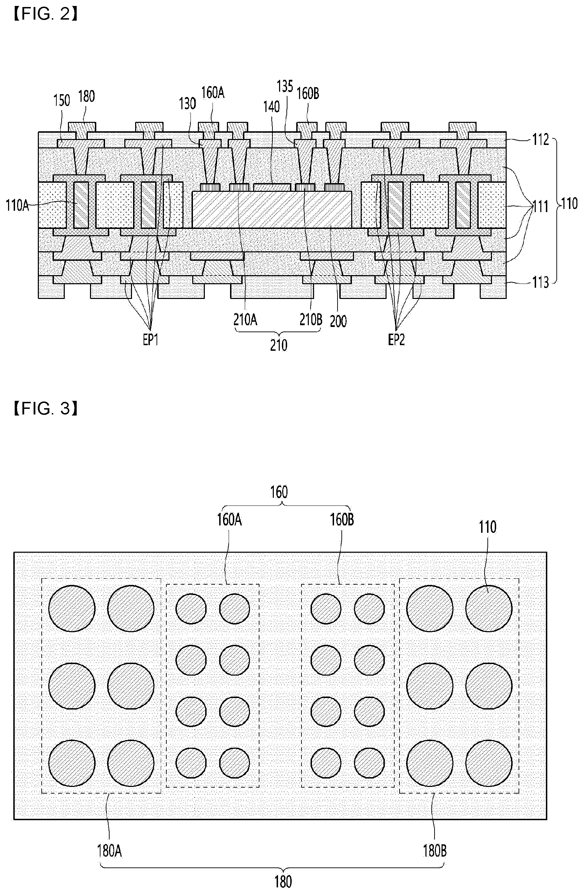

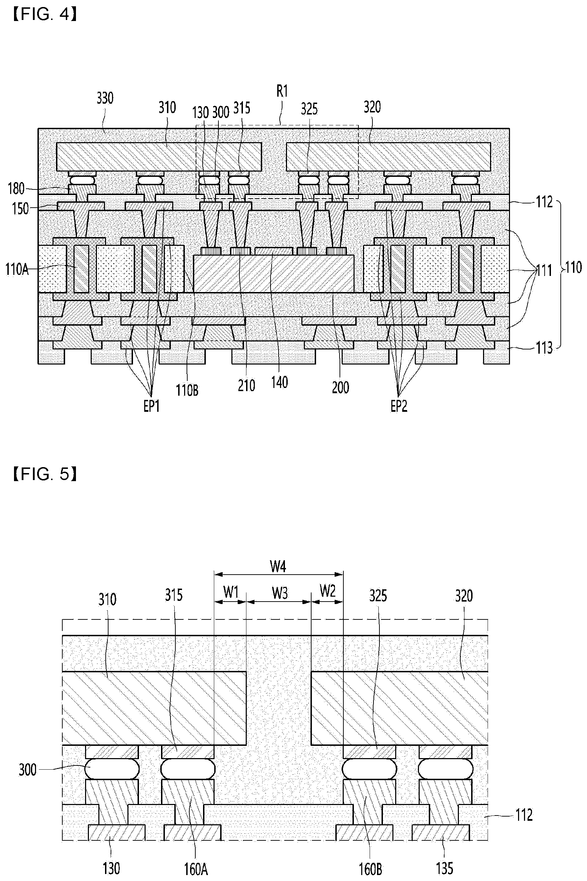

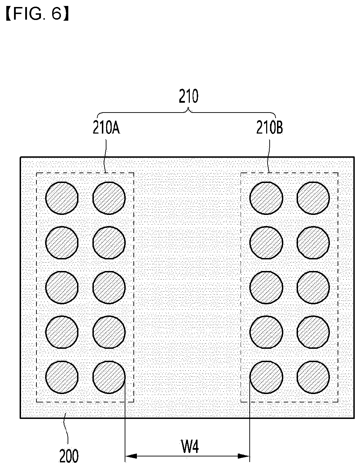

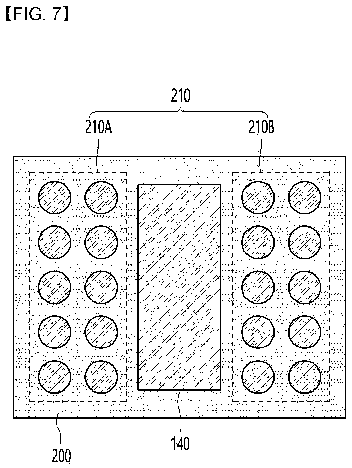

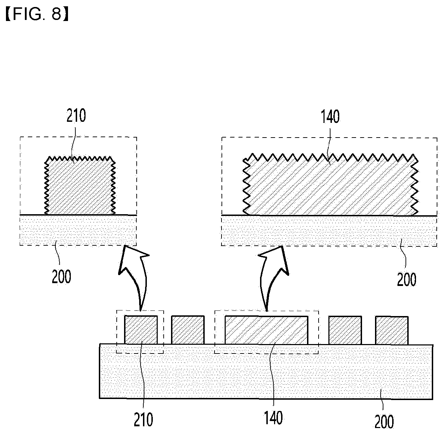

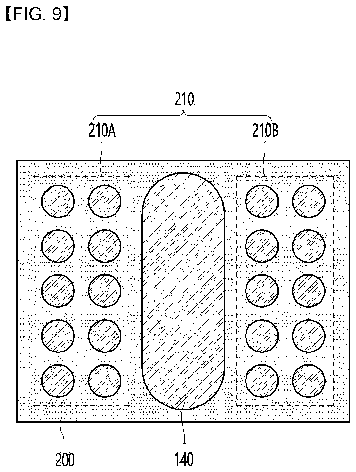

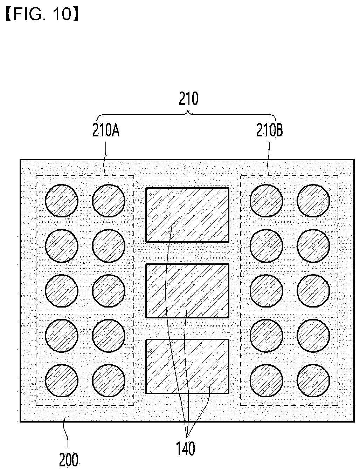

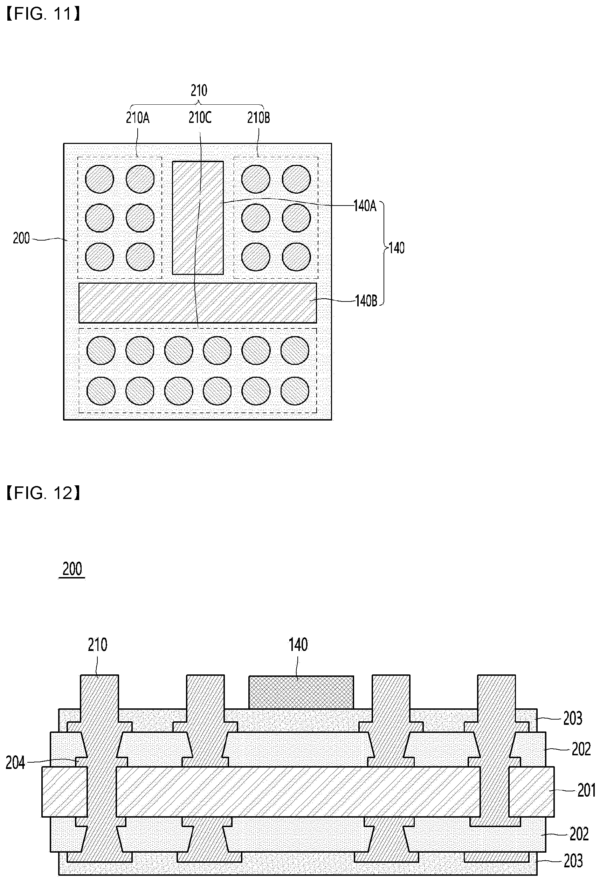

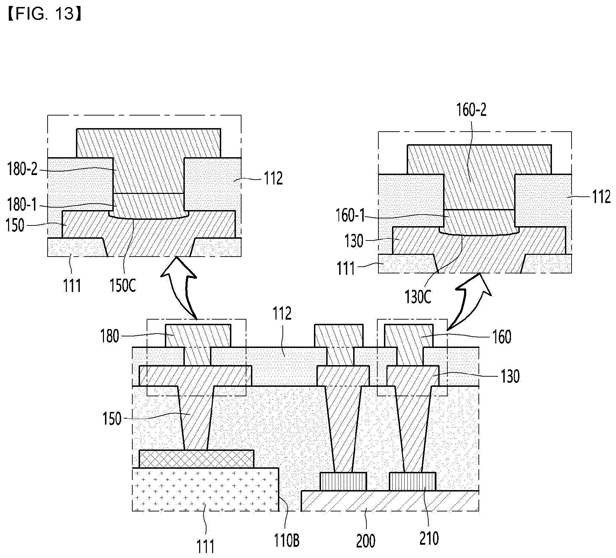

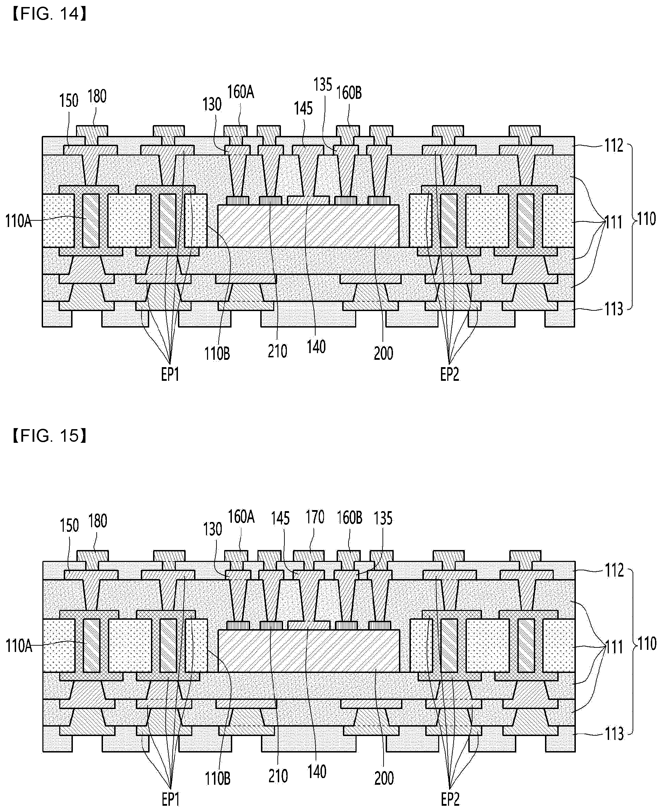

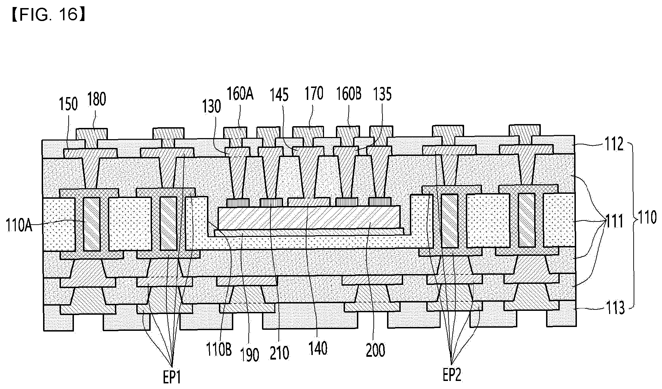

FIG. 2 is a cross-sectional view showing a circuit board according to a first embodiment, FIG. 3 is a plan view of the circuit board of FIG. 2 viewed from an upward direction, FIG. 4 is a cross-sectional view of a semiconductor package including a circuit board of FIG. 2, FIG. 5 is an enlarged view of a partial region of FIG. 4, FIG. 6 is a plan view of a connection member embedded in the circuit board of FIG. 2 viewed from an upward direction, FIG. 7 is a plan view of a connection member including a dummy electrode disposed on a connection member according to the first embodiment, FIG. 8 is a cross-sectional view showing a surface roughness of the connection electrode and the dummy electrode of FIG. 7, FIG. 9 is a plan view of a connection member including a dummy electrode disposed in a connection member according to a second embodiment, FIG. 10 is a plan view of a connection member including a dummy electrode disposed in a connection member according to a third embodiment, FIG. 11 is a plan view of a connection member including a dummy electrode disposed in a connection member according to a fourth embodiment, FIG. 12 is a drawing showing a detailed layer structure of a connection member according to one embodiment, FIG. 13 is a cross-sectional view showing a detailed layer structure of a protruding electrode included in the circuit board of FIG. 2, FIG. 14 is a cross-sectional view showing a circuit board according to a second embodiment, FIG. 15 is a cross-sectional view showing a circuit board according to a third embodiment, and FIG. 16 is a cross-sectional view showing a circuit board according to a fourth embodiment.

Hereinafter, a semiconductor package according to an embodiment will be specifically described with reference to FIGS. 2 to 16.

Referring to FIG. 2, a circuit board according to a first embodiment may include an insulating part 110, an electrode part, and a connection member 200. The insulating part 110 may include an insulating layer 111, a first protective layer 112, and a second protective layer 113.

The insulating layer 111 may have a layer structure of at least one layer. Preferably, the insulating layer 111 may have a build-up structure in which a plurality of layers are laminated along a vertical direction. It may have a plurality of laminated structures. The laminated structures may be distinguished by the electrode part. For example, the electrode part may include a wiring electrode EP1 and a through electrode EP2. The wiring electrode EP1 and the through electrode EP2 may have different widths. In addition, the laminated structures may be distinguished by a difference in the widths of the wiring electrode EP1 and the through electrode EP2. The wiring electrode EP1 may have a wider width than the through electrode EP2. Through this, the wiring electrode EP1 and the through electrode EP2 can be distinguished in the electrode part. The wiring electrode EP1 may mean a pad and/or a trace of the electrode part. The through electrode EP2 may mean a via electrode connected to the connection electrode. The through electrode EP2 may be disposed between a plurality of wiring electrodes EP1 disposed in different layers. By the above-described laminated structure, the circuit board of the embodiment may electrically efficiently connect at least one semiconductor device and/or the second circuit board to the main board.

In addition, when a plurality of layers of the insulating layer 111 include a same insulating material, an interface between the plurality of layers may not be distinguished. In this case, the laminated structure may be distinguished by the wiring electrode EP1 and the through electrode EP2 of the electrode part.

The insulating layer 111 may be rigid or flexible. For example, the insulating layer 111 may include glass or plastic. For example, the insulating layer 111 may include chemically strengthened/semi-strengthened glass such as soda lime glass or aluminosilicate glass. For example, the insulating layer 111 may include reinforced or flexible plastic such as polyimide (PI), polyethylene terephthalate (PET), propylene glycol (PPG), polycarbonate (PC). For example, the insulating layer 111 may include sapphire. For example, the insulating layer 111 may include an optically isotropic film. For example, the insulating layer 111 may include cyclic olefin copolymer (COC), cyclic olefin polymer (COP), optically isotropic polycarbonate (PC), or optically isotropic polymethyl methacrylate (PMMA). For example, the insulating layer 111 may be formed of a material including an inorganic filler and an insulating resin. For example, the insulating layer 111 may have a structure in which an inorganic filler of silica or alumina is disposed in a thermosetting resin or a thermoplastic resin.

The insulating layer 111 may have a structure in which a plurality of different insulating materials are laminated, and an exemplary arrangement structure will be described in more detail as follows.

In one embodiment, the insulating layer 111 may include a first insulating layer corresponding to a core layer including a reinforcing member. Here, the core layer may mean an insulating layer including a reinforcing member and having a thickness in a vertical direction exceeding 30 µm. In addition, the insulating layer may include an upper build-up insulating layer disposed at an upper portion of the core layer and a lower build-up insulating layer disposed at an lower portion of the core layer. In one embodiment, the upper build-up insulating layer and/or the lower build-up insulating layer may not have a reinforcing member. In this case, the circuit board may be a core board. The reinforcing member may also be referred to as reinforcing fiber or glass fiber.

The reinforcing member may mean a glass fiber material extending along the horizontal direction of the insulating layer, and may have a different meaning from an inorganic filler spaced apart from each other. That is, the reinforcing member of the core layer may have a different length or width along the horizontal direction from the filler of the upper and/or lower build-up insulating layer. In addition, the reinforcing member of the core layer may have a structure extending long along one direction, but since the filler of the upper and/or lower build-up insulating layer has an arbitrary size and is disposed to disperse in the upper and/or lower build-up insulating layer, the reinforcing member of the core layer and the filler of the upper and/or lower build-up insulating layer may be distinguished from each other. For example, the glass fiber may be extended to have a surface length greater than a width of the core layer. Here, the meaning of having a surface length greater than the width of the core layer may mean that the glass fiber may be disposed in a shape that is bent in the horizontal direction. In addition, since the upper and/or lower build-up insulating layers do not have a greater effect in preventing problems such as warpage than the glass fiber of the core layer even if they contain fillers, the reinforcing member is described separately from the filler of the upper and/or lower build-up insulating layers.

In another embodiment, the insulating layer 111 may be a coreless circuit board that does not contain a core layer. For example, the insulating layer 111 may include an organic material that does not include a reinforcing member so as to have excellent processability, enable slimming of the circuit board, and enable miniaturization of the electrode part of the circuit board. For example, the insulating layer 111 may use ABF (Ajinomoto Build-up Film), a product released by Ajinomoto Co., Ltd., and FR-4, BT (Bismaleimide Triazine), PID (Photo Imageable Dielectric resin), BT, etc. may be used. For example, the insulating layer 111 may have a structure in which a plurality of build-up insulating layers composed of ABF are laminated along a vertical direction. When the insulating layer 111 is composed only of ABF that does not include a reinforcing member, the rigidity of the circuit board may be reduced. Therefore, the insulating layer 111 may be composed of ABF (Ajinomoto Build-up Film), and at least one of the plurality of build-up insulating layers constituting the insulating layer 111 of the circuit board may include a reinforcing member. For example, the insulating layer 111 may include a first insulating layer composed of a first ABF including a resin and a filler. In addition, the insulating layer 111 may include a second insulating layer composed of a second ABF including a resin, a filler, and a reinforcing member. At this time, the reinforcing member included in the second ABF may include a GCP (Glass Core Primer) material, but is not limited thereto.

A layer in the insulating layer 111 that does not include the reinforcing member can have a thickness in a range of 10 µm to 40 µm. Preferably, the layer in the insulating layer 111 that does not include the reinforcing member can satisfy a thickness in a range of 15 µm to 35 µm. More preferably, the layer in the insulating layer 111 that does not include the reinforcing member can satisfy a thickness in a range of 18 µm to 32 µm. If the thickness of the layer in the insulating layer 111 that does not include the reinforcing member is less than 10 µm, the rigidity of the circuit board may be deteriorated. In addition, if the thickness of the layer in the insulating layer 111 that does not include the reinforcing member is less than 10 µm, the electrode part of the circuit board may not be stably protected, and thus the electrical reliability may be deteriorated. In addition, if the thickness of the layer in the insulating layer 111 that does not include the reinforcing member exceeds 40 µm, an overall thickness of the circuit board may increase, and thus a thickness of the semiconductor package may increase. In addition, if the thickness of the layer in the insulating layer 111 that does not include the reinforcing member exceeds 40 µm, it may be difficult to miniaturize the electrode part of the circuit board.

The thickness may correspond to a distance in the vertical direction of the circuit board between the wiring electrodes EP1 disposed in different layers. That is, the thickness may mean a length in a direction from the upper surface to the lower surface of the circuit board, or from the lower surface to the upper surface, and may mean a length in the vertical direction of the circuit board. Here, the upper surface may mean a highest position along the vertical direction in each component, and the lower surface may mean a lowest position along the vertical direction in each component. In addition, the positions thereof may be referred to oppositely.

The insulating part 110 may include a first protective layer 112 and a second protective layer 113. The first protective layer 112 and the second protective layer 113 of the circuit board may be resist layers. For example, the first protective layer 112 of the circuit board may be a first resist layer disposed at an uppermost side of the circuit board. In addition, the second protective layer 113 of the circuit board may be a second resist layer disposed at a lowermost side of the circuit board.

In one embodiment, the first protective layer 112 and the second protective layer 113 of the circuit board may include a same insulating material as the insulating layer 111. In this case, it may be difficult to distinguish an interface between the insulating layer 111 and the first protective layer 112 and the second protective layer 113. In this case, the wiring electrode EP1 and the through electrode EP2 of the electrode part disposed in the insulating layer 111, the first protective layer 112, and the second protective layer 113 can be used to distinguish the interface between the insulating layer 111, the first protective layer 112, and the second protective layer 113.

The circuit board may include the electrode part. The electrode part may include a first electrode part 130, a second electrode part 135, a third electrode part 140, and a fourth electrode part 150 disposed in the insulating layer 100.

The first electrode part 130, the second electrode part 135, and the third electrode part 140 may mean electrodes that are vertically overlapped with the connection member 200 within the insulating layer 100.

The fourth electrode part 150 may mean an electrode that does not vertically overlap with the connection member 200 within the insulating layer 100.

The first electrode part 130 and the second electrode part 135 may mean electrodes that are electrically connected to the connection member 200.

For example, the connection member 200 may have a connection electrode 210. The connection electrode 210 may include a first connection electrode 210A and a second connection electrode 210B spaced apart from the first connection electrode 210A.

The first electrode part 130 may be an electrode that vertically overlaps with the first connection electrode 210A of the connection member 200. For example, the first electrode part 130 may be an electrode that is electrically connected to the first connection electrode 210 of the connection member 200.

The second electrode part 135 may be an electrode that is vertically overlapped with the second connection electrode 210B of the connection member 200. For example, the second electrode 210B may be an electrode that is electrically connected to the second connection electrode 210B of the connection member 200.

In one embodiment, the third electrode part 140 may be disposed between the first electrode part 130 and the second electrode part 135. In another embodiment, the third electrode part 140 may be disposed between the first connection electrode 210A and the second connection electrode 210B of the connection member 200.

The third electrode part 140 may be electrically floated with the connection member 200. For example, the third electrode part 140 may be a dummy electrode. For example, the third electrode part 140 may be a dummy electrode that is electrically floating with the connection member 200 and the semiconductor device while being positioned between the connection member 200 and the semiconductor device. The third electrode part 140 may be positioned between the first electrode part 130 and the second electrode part 135 or between the first connection electrode 210A and the second connection electrode 210B of the connection member 200 and may have a function of improving adhesion between the insulating layer 100 and the connection member 200. Here, in one embodiment, the third electrode part 140 may be a component of an electrode part of a circuit board that is distinct from the connection electrodes of the connection member 200. In this case, the embodiment may perform a process of forming a third electrode part 140 so as to horizontally overlap the first and second connection electrodes 210A and 210B of the connection member 200 and electrically float with the first and second connection electrodes 210A and 210B after performing a process of embedding the connection member 200 in the insulating layer 111 in a manufacturing process of the circuit board. In another embodiment, the third electrode part 140 may be a component of the connection member 200. In this case, the connection member 200 may be provided in a state where the third electrode part 140 is disposed between the first and second connection electrodes 210A and 210B.

The connection member 200 can perform a function of horizontally connecting terminals of a plurality of semiconductor devices. That is, a plurality of semiconductor devices can be disposed on a circuit board and spaced apart in a horizontal direction. The plurality of semiconductor devices can exchange signals with each other. Therefore, terminals provided in each of the plurality of semiconductor devices include terminals connected to each other. At this time, functions provided by the plurality of semiconductor devices are increasing, and accordingly, a number of terminals provided in the plurality of semiconductor devices is also increasing. Accordingly, a number of terminals that need to be connected to each other among the terminals provided in the plurality of semiconductor devices is also increasing. In addition, a size of the terminals provided in the plurality of semiconductor devices is becoming smaller due to miniaturization of semiconductor packages and/or miniaturization of the plurality of semiconductor devices. Therefore, it may be difficult to connect the terminals of the plurality of semiconductor devices only with the electrodes provided in the circuit board within a limited space. Furthermore, a size of the electrodes provided in the circuit board is significantly different from the size of the terminals provided in the semiconductor devices, and accordingly, if they are connected only with the electrodes provided in the circuit board, signal transmission loss may increase and signal transmission characteristics may deteriorate. A connection member 200 may be embedded in the circuit board, and the connection member 200 may electrically connect terminals that should be connected to each other among terminals of a plurality of semiconductor devices.

The connection member 200 may include a connection electrode 210, and the connection electrode 210 may include first and second connection electrodes 210A and 210B. The first connection electrode 210A and the second connection electrode 210B may be provided on the connection member 200 at a predetermined distance in the horizontal direction, considering positions of terminals of the first and second semiconductor devices disposed on the circuit board, and the horizontal separation distance between the first and second semiconductor devices. An upper surface of the connection member 200 may include a first region where the first connection electrode 210A is disposed, a second region where the second connection electrode 210B is disposed, and a third region where no connection electrode is disposed between the first and second regions.

The connection electrode 210 provided in the connection member 200 may have a high density and may have a relatively low surface roughness value for this purpose. Accordingly, since the connection electrode 210 of the connection member 200 has a relatively low surface roughness value and the connection electrode 210 is not disposed in a certain region of the upper surface of the connection member 200, the adhesion between the insulating layer 100 and the connection member 200 may be reduced. As a result, a problem may occur in which the connection member 200 is peeled off from the insulating layer 100. In addition, various thermal stresses may occur in a manufacturing process and/or usage environment of the semiconductor package, and a problem may occur in which cracks occur in the connection member 200, peeling of the connection member 200 occurs, or the connection member 200 is greatly bent in a specific direction due to the thermal stress.

Therefore, the embodiment may include a third electrode part 140 disposed on the connection member 200. The third electrode part 140 may be an electrode formed through a separate process from the connection electrode 210 of the connection member 200. However, it is not limited thereto, and the third electrode part 140 may be formed together with the connection electrode 210 in a process of manufacturing the connection member 200. In this case, a process of embedding the connection member 200 in the insulating layer 100 may be performed while the third electrode part 140 is disposed on the connection member 200 together with the connection electrode 210.

The third electrode part 140 may be physically combined with the connection member 200 while being electrically floated with the connection member 200.

Through this, the third electrode part 140 may have a function of improving the adhesion between the connection member 200 and the insulating layer 100. Through this, the embodiment can solve the mechanical reliability problem of the connection member 200 being peeled off from the insulating layer 100 by using the third electrode part 140. Furthermore, the third electrode part 140 can have a function of increasing the rigidity of the connection member 200 and/or the circuit board. For example, the third electrode part 140 can be coupled to the connection member 200, thereby preventing the connection member 200 and/or the circuit board from being greatly bent in a specific direction. Through this, the embodiment can enable a plurality of semiconductor devices disposed on the circuit board to operate stably. Furthermore, the embodiment can enable electronic products and/or servers to which the semiconductor package is applied to operate smoothly.

Meanwhile, the fourth electrode part 150 can be horizontally overlapped with the first electrode part 130 and the second electrode part 135 without being vertically overlapped with the connection member 200.

The fourth electrode part 150 may be an electrode connected to a semiconductor device. For example, the fourth electrode part 150 may be connected to a semiconductor device connected to each of the first electrode part 130 and the second electrode part 135.

The electrode part of the embodiment may include a protruding electrode. For example, the electrode part may include a first protruding electrode 160A disposed on the first electrode part 130. In addition, the electrode part may include a second protruding electrode 160B disposed on the second electrode part 135. In addition, the electrode part may include a third protruding electrode 180 disposed on the fourth electrode part 150.

The first protruding electrode 160A, the second protruding electrode 160B, and the third protruding electrode 180 may penetrate from the upper surface of the insulating layer 100 to a portion of the insulating layer 100.

In addition, the first protruding electrode 160A, the second protruding electrode 160B, and the third protruding electrode 180 may protrude above an upper surface of the insulating layer 100.

The first protruding electrode 160A, the second protruding electrode 160B, and the third protruding electrode 180 may improve the bonding between a plurality of semiconductor devices and a circuit board.

The first protruding electrode 160A, the second protruding electrode 160B, and the third protruding electrode 180 may be referred to as bumps. The first protruding electrode 160A, the second protruding electrode 160B, and the third protruding electrode 180 may also be referred to as posts. The first protruding electrode 160A, the second protruding electrode 160B, and the third protruding electrode 180 may also be referred to as pillars. Preferably, the first protruding electrode 160A, the second protruding electrode 160B, and the third protruding electrode 180 may refer to electrodes on which a conductive bonding member for bonding with a semiconductor device is disposed. That is, as a pitch of the terminals of the semiconductor device becomes finer, a short circuit may occur between a plurality of conductive bonding members which are respectively connected to a plurality of terminals of the semiconductor device by a conductive adhesive such as solder. Therefore, the embodiment may perform thermal compression bonding to reduce a volume of the conductive bonding member. Accordingly, the embodiment may provide a first protruding electrode 160A, a second protruding electrode 160B, and a third protruding electrode 180 to secure alignment, diffusion, and diffusion-preventing power to prevent an intermetallic compound (IMC) formed between a conductive adhesive such as solder and a protruding part from diffusing into the circuit board.

According to the embodiment of FIGS. 3 and 4, a first semiconductor device 310 and a second semiconductor device 320 may be mounted on the circuit board. The first semiconductor device 310 may include a plurality of first terminals 315. In addition, the second semiconductor device 320 may include a plurality of second terminals 325.

The first semiconductor device 310 and the second semiconductor device 320 may be electrically coupled to the first protruding electrode 160A, the second protruding electrode 160B, and the third protruding electrode 180 provided on the circuit board. To this end, a conductive adhesive member 300 may be provided between the first terminal 315 of the first semiconductor device 310 and the second terminal 325 of the second semiconductor device 320 and the first protruding electrode 160A, the second protruding electrode 160B, and the third protruding electrode 180.

In addition, a molding member 330 may be provided on the circuit board. The molding member 330 may be disposed on the circuit board, and the first semiconductor device 310 and the second semiconductor device 320 may be molded through the molding member.

The first protruding electrode 160A may mean a bonding electrode electrically connected to the first terminal 315 of the first semiconductor device 310. The second protruding electrode 160B may mean a bonding electrode electrically connected to the second terminal 325 of the second semiconductor device 320.

The first protruding electrode 160A and the second protruding electrode 160B may be spaced apart from each other in the horizontal direction. For example, the first protruding electrode 160A and the second protruding electrode 160B may be spaced apart from each other by a predetermined horizontal distance based on positions of the first terminal 315 provided in the first semiconductor device 310 and the second terminal 325 provided in the second semiconductor device 320 and a separation distance between the first semiconductor device 310 and the second semiconductor device 320.

Meanwhile, the third protruding electrode 180 may include third protruding electrode 180A of a first group and third protruding electrode 180B of a second group. The third protruding electrode 180A of the first group may be disposed adjacent to the first protruding electrode 160A. For example, the third protruding electrode 180A of the first group may be disposed at one side of the first protruding electrode 160A. The third protruding electrode 180A of the first group may overlap the first semiconductor device 310 in a vertical direction. The third protruding electrode 180A of the first group may be connected to the first terminal 315 of the first semiconductor device 310. The third protruding electrode 180B of the second group may be disposed adjacent to the second protruding electrode 160B. For example, the third protruding electrode 180B of the second group may be disposed at the other side of the second protruding electrode 160B. The third protruding electrode 180B of the second group may overlap the second semiconductor device 320 in the vertical direction. The third protruding electrode 180B of the second group may be connected to the second terminal 325 of the second semiconductor device 320.

Each of the first protruding electrode 160A and the second protruding electrode 160B may be provided in multiple units spaced apart from each other along the horizontal direction, and the third protruding electrode 180 may also be provided in multiple units spaced apart from each other along the horizontal direction.

According to the embodiment of FIG. 5, a plurality of first terminals 315 may be provided on one surface of the first semiconductor device 310. The first terminal 315 may be spaced apart from an edge of one surface of the first semiconductor device 310 by a first spacing W1. For example, among the plurality of first terminals provided on the first semiconductor device 310, a first terminal that is disposed closest to the edge of one surface of the first semiconductor device 310 may be spaced apart from the edge of the first semiconductor device 310 by a first spacing W1.

In addition, a plurality of second terminals 325 may be provided on one surface of the second semiconductor device 320. The second terminals 325 may be spaced apart from an edge of one surface of the second semiconductor device 320 by a second spacing W2. For example, among the plurality of second terminals provided in the second semiconductor device 320, the second terminal most adjacent to the edge of the one surface of the second semiconductor device 320 may be spaced apart from the edge of the second semiconductor device 320 by a second spacing W2.

At this time, each of the first spacing W1 and the second spacing W2 may satisfy a range of 40 µm to 80 µm. Preferably, each of the first spacing W1 and the second spacing W2 may satisfy a range of 45 µm to 75 µm. More preferably, each of the first spacing W1 and the second spacing W2 may satisfy a range of 50 µm to 70 µm.

If each of the first spacing W1 and the second spacing W2 is less than 40 µm, the mechanical reliability and/or electrical reliability of the first terminal 315 and/or the second terminal 325 may be deteriorated. For example, if each of the first spacing W1 and the second spacing W2 is less than 40 µm, an impact may be applied to the electrode disposed closest to the edge during a sawing process in a process of manufacturing the first semiconductor device 310 and/or the second semiconductor device 320, and a problem of cracks occurring in the electrode or peeling of the electrode may occur due to the impact. In addition, if each of the first spacing W1 and the second spacing W2 exceeds 80 µm, a dummy region in which the first terminal and/or the second terminal is not disposed may increase by an area corresponding thereto. In addition, when the dummy region increases, the size of the first semiconductor device 310 and/or the second semiconductor device 320 may increase, which may increase the size of the semiconductor package, and further, it may be difficult to miniaturize the size of electronic products or servers.

The first semiconductor device 310 and the second semiconductor device 320 may be disposed on the circuit board to be spaced apart by a third spacing W3. The third spacing W3 may satisfy a range of 80 µm to 150 µm. Preferably, the third spacing W3 may satisfy a range of 85 µm to 140 µm. More preferably, the third spacing W3 may satisfy a range of 90 µm to 120 µm.

If the third spacing W3 is less than 80 µm, a separation distance between the first semiconductor device 310 and the second semiconductor device 320 becomes narrow, and thus, the processability in a process of mounting the first semiconductor device 310 and the second semiconductor device 320 on the circuit board may be deteriorated. For example, if the third spacing W3 is less than 80µm, during the process of mounting the second semiconductor device 320 after mounting the first semiconductor device 310, the two semiconductor devices may come into contact with each other or a space may not be secured for the mounting process of the second semiconductor device 320, and thus, a problem may occur in which the first semiconductor device 310 and/or the second semiconductor device 320 are not stably mounted. In addition, if the third spacing W3 is less than 80µm, as the distance between them becomes narrower, a circuit short problem may occur in which electrodes that should not be connected to each other among the first terminal 315 of the first semiconductor device 310 and the second terminal 325 of the second semiconductor device 320 are connected to each other.

In addition, if the third spacing W3 exceeds 150µm, a separation distance between the first semiconductor device 310 and the second semiconductor device 320 may become too large, and thus a signal transmission distance between them may increase, and signal transmission loss may also increase in proportion to the increase in the signal transmission distance. As a result, the communication characteristics may deteriorate. In addition, if the third spacing W3 exceeds 150µm, a size of the semiconductor package may increase.

Accordingly, a first terminal 315 and a second terminals 325 that are arranged closest to each other in the first semiconductor device 310 and the second semiconductor device 320 can be spaced apart by a fourth spacing W4. The fourth spacing W4 may be determined by a sum of the first spacing W1, the second spacing W2, and the third spacing W3.

For example, the fourth spacing W4 may satisfy a range of 160 µm to 310 µm. In addition, if the fourth spacing W4 is less than 160 µm or exceeds 310 µm, one of the first spacing W1, the second spacing W2, and the third spacing W3 may not satisfy the range, and thus, the problem described above may occur.

Referring to FIG. 6, the connection member 200 may include a first connection electrode 210A connected to a first terminal 315 of the first semiconductor device 310 and a second connection electrode 210B connected to a second terminal 325 of the second semiconductor device 320.

The first connection electrode 210A of the connection member 200 may vertically overlap with the first terminal 315 of the first semiconductor device 310. In addition, the second connection electrode 210B of the connection member 200 may be vertically overlapped with the second terminal 325 of the second semiconductor device 320.

At this time, electrodes most adjacent to each other among the first terminal 315 and the second terminal 325 may be spaced apart by the fourth spacing W4.

Accordingly, the first connection electrode 210A and the second connection electrode 210B provided in the connection member 200 may also be spaced apart by the fourth spacing W4. For example, an upper surface of the connection member 200 may be provided with a region where the connection electrode 210 is not disposed corresponding to the fourth spacing W4.

Referring to FIG. 7, the embodiment may perform a process of forming a third electrode part 140 on the connection member 200 in a state where the connection member 200 is disposed on the insulating layer 111. The third electrode part 140 may be provided in a region between the first connection electrode 210A and the second connection electrode 210B provided in the connection member 200. The third electrode part 140 may physically contact the connection member 200 and may be electrically floated.

Meanwhile, the first connection electrode 210A of the connection member 200 may include a plurality of connection electrodes. In addition, the second connection electrode 210B of the connection member 200 may include a plurality of connection electrodes.

At this time, a plane area of the third electrode part 140 may be larger than a plane area of a single electrode of the first connection electrode 210A and a plane area of a single electrode of the second connection electrode 210B. Preferably, the third electrode part 140 may be provided as a single unit, and the plane area of the third electrode part 140 may be larger than each of the plane area of the single electrode of the first connection electrode 210A and the plane area of the single electrode of the second connection electrode 210B. For example, the third electrode part 140 may be provided as a plurality of units, and at this time, the plane area of the single electrode of the third electrode part 140 may be larger than each of the plane area of the single electrode of the first connection electrode 210A and the plane area of the single electrode of the second connection electrode 210B.

Through this, the plane area of the single electrode of the third electrode part 140 is larger than the plane area of the single electrode of the first connection electrode 210A and the plane area of the single electrode of the second connection electrode 210B, and accordingly, the embodiment can further improve the adhesion between the connection member 200 and the insulating layer 111 by the third electrode part 140, thereby solving the problem of the connection member 200 being peeled off from the insulating layer 100. Furthermore, the embodiment can maximize an effect of improving the rigidity of the connection member 200 and/or an effect of improving the rigidity of the circuit board by the third electrode part 140, thereby solving the problem of the connection member 200, the circuit board, and/or the semiconductor package being greatly bent in a specific direction.

Referring to FIG. 8, the connection electrode 210 of the connection member 200 and the third electrode part 140 can have different surface roughnesses. The connection electrode 210 of the connection member 200 may have a relatively small surface roughness value in order to minimize signal transmission loss due to a skin effect. In contrast, the third electrode part 140 is a dummy electrode rather than an electrode through which a signal is transmitted, and accordingly, the third electrode part 140 may have a surface roughness value greater than the surface roughness value of the connection electrode 210 of the connection member 200.

Through this, the embodiment may further enhance the adhesion between the insulating layer 100 and the third electrode part 140 by making the surface roughness value of the third electrode part 140 relatively large, and further enhance the adhesion between the connection member 200 physically coupled to the third electrode part 140 and the insulating layer 100.

Referring to FIG. 9, a planar shape of the third electrode part 140 may have various shapes. For example, the planar shape of the third electrode part 140 in the previous embodiment is illustrated as having a square shape, but is not limited thereto. For example, the planar shape of the third electrode part 140 may have a circular shape or an oval shape. In addition, the planar shape of the third electrode part 140 may be modified into a triangular shape or a polygonal shape, etc.

Referring to FIG. 10, the third electrode part 140 may include a plurality of dummy electrode patterns. For example, the third electrode part 140 in the previous embodiment is provided as a single electrode between the first connection electrode 210A and the second connection electrode 210B of the connection member 200, but is not limited thereto. For example, the third electrode part 140 may include a plurality of dummy electrode patterns spaced apart from each other in a region between the first connection electrode 210A and the second connection electrode 210B of the connection member 200. At this time, when the third electrode part 140 includes a plurality of dummy electrode patterns, a contact area between the insulating layer 100 and the third electrode part 140 can be further increased, and thus the adhesion between the insulating part 110 and the connection member 200 can be further improved.

Meanwhile, although the first semiconductor device 310 and the second semiconductor device 320 are illustrated as being disposed on the circuit board in the previous embodiment, the embodiment is not limited thereto.

For example, the semiconductor package may include a first semiconductor device 310 and a second semiconductor device 320 spaced apart in a first horizontal direction, and may include a third semiconductor device spaced apart from the first semiconductor device 310 and the second semiconductor device 320 in a second horizontal direction different from a first horizontal direction.

As illustrated in FIG. 11, the connection electrode 210 of the connection member 200 may include a first connection electrode 210A vertically overlapping with a terminal of the first semiconductor device 310, a second connection electrode 210B vertically overlapping with the second semiconductor device 320, and a third connection electrode 210C vertically overlapping with the third semiconductor device.

In addition, the third electrode part 140 may include a first dummy electrode 140A provided between the first connection electrode 210A and the second connection electrode 210B on the connection member 200, and a second dummy electrode 140B provided between the first connection electrode 210A, the second connection electrode 210B, and the third connection electrode 210C.

The detailed layer structure of the connection member 200 is described below. The connection member 200 may be an inorganic bridge. For example, the inorganic bridge may be a silicon bridge. Accordingly, the connection member 200 may include an insulating member including a silicon material, and connection electrodes disposed on the insulating member. In another embodiment, the connection member 200 may be an organic bridge. For example, the organic bridge may include an organic insulating layer. For example, the connection member 200 may include a plurality of organic insulating layers.

Specifically, according to the embodiment of FIG. 12, the connection member 200 may include a first insulating layer 201, a second insulating layer 202, and a third insulating layer 203.

In addition, the first insulating layer 201, the second insulating layer 202, and the third insulating layer 203 may include different insulating materials. However, the embodiment is not limited thereto. For example, the first insulating layer 201 may include an organic material. The first insulating layer 201 may include a different material from the second insulating layer 202, but is not limited thereto.

The first insulating layer 201 may have a characteristic that enables a formation of an electrode layer 206 of the connection member 200 including a micro electrode pattern. For example, the first insulating layer 201 may include an insulating material having excellent processability and elasticity. For example, the first insulating layer 201 of the connection member 200 may include polyimide (PI). In this case, the connection member of a prior art was an inorganic bridge, for example, a silicon bridge. The silicon has a coefficient of thermal expansion that is different from a coefficient of thermal expansion of the insulating layer 111, and thus may have a problem in that cracks easily occur due to thermal stress. The first insulating layer 201 of the connection member 200 of another embodiment may include an organic material having a similar coefficient of thermal expansion to that of the insulating layer 111. Through this, the embodiment may minimize stress applied to the connection member 200. Furthermore, the embodiment may solve a problem in which cracks occur in the connection member 200 or the connection member 200 is peeled off from the circuit board. Through this, the embodiment may improve mechanical reliability and electrical reliability of the semiconductor package.

In addition, when the first insulating layer 201 of the connection member 200 includes polyimide, a cost of the connection member 200 can be reduced compared to a silicon bridge.

In addition, the connection member 200 may be provided with via electrodes having a small width. In addition, an alignment state between the plurality of via electrodes provided in different layers can have a great influence on operating characteristics of the connection member 200, operating characteristics of the semiconductor package, and operating characteristics of the electronic product or server to which the semiconductor package is applied. At this time, the polyimide can have a transparent characteristic. Accordingly, the embodiment can improve the alignment state of the plurality of via electrodes provided in different layers. Through this, the operating characteristics of the connection member 200, the operating characteristics of the semiconductor package, and the operating characteristics of the electronic product or server to which the semiconductor package is applied can be further improved.

In addition, the first insulating layer 201 can mean an insulating layer provided in an inner layer of the connection member 200. In addition, overall characteristics of the connection member 200 can be determined by characteristics of the first insulating layer 201. At this time, the first insulating layer 201 can have elasticity while having a similar coefficient of thermal expansion to that of the insulating layer of the circuit board. By this, the first insulating layer 201 of the connection member 200 can flow together with the circuit board when the circuit board is thermally deformed. Through this, the embodiment can solve a problem of cracks in the connection member 200 that may occur due to thermal deformation of the circuit board.

In addition, the embodiment can easily control a thickness of the connection member 200 by making the first insulating layer 201 of the connection member 200 include polyimide (PI). Through this, the embodiment can minimize a difference between a depth of a cavity C, which is an accommodation space of the connection member 200 formed in the circuit board, and a thickness of the connection member 200. Through this, the embodiment can minimize a height difference between the first electrode part 130 and the fourth electrode part 150 and/or a height difference between the first protruding electrode 160A, the second protruding electrode 160B, and the third protruding electrode 180. Through this, the embodiment can stably couple a semiconductor device onto the first protruding electrode 160A, the second protruding electrode 160B, and the third protruding electrode 180.

The connection member 200 may include a second insulating layer 202 disposed on the first insulating layer 201. The second insulating layer 202 may include an insulating material different from that of the first insulating layer 201, but is not limited thereto. For example, the second insulating layer 202 may include polyimide, which is the same insulating material as that of the first insulating layer 201. For example, the first insulating layer 201 may include an insulating material identical to that of the second insulating layer 202 described below instead of the polyimide.

The second insulating layer 202 may include a photosensitive material. For example, the second insulating layer 202 may include PID. For example, the second insulating layer 202 may be a PID in which a photosensitive material is a resin layer and a filler is dispersed within the resin layer.

In another embodiment, the second insulating layer 202 may include a same insulating material as the insulating layer 111. For example, the second insulating layer 202 may include ABF, which is a same insulating material as the insulating layer 111. Meanwhile, the second insulating layer 202 may be disposed on each of both surfaces of the first insulating layer 201.

In addition, the connection member 200 may include a third insulating layer 203 disposed on the second insulating layer 202. The third insulating layer 203 may be a protective layer. For example, the third insulating layer 203 may be a solder resist layer.

At this time, a side surface of the connection member 200 may have a step. For example, the first insulating layer 201, the second insulating layer 202, and the third insulating layer 203 of the connection member 200 may have steps.

For example, a width of the first insulating layer 201 of the connection member 200 in the horizontal direction may be different from a width of the second insulating layer 202 in the horizontal direction and a width of the third insulating layer 203 in the horizontal direction. Preferably, the width of the first insulating layer 201 of the connection member 200 in the horizontal direction may be larger than the width of the second insulating layer 202 in the horizontal direction and the width of the third insulating layer 203 in the horizontal direction.

That is, among the insulating layers of the connection member 200, the elasticity and/or rigidity of the first insulating layer 201 may be a highest compared to the second insulating layer 202 and the third insulating layer 203. Accordingly, the embodiment allows the first insulating layer 201 of the connection member 200 to have a largest width. Accordingly, the embodiment allows an impact applied to the connection member 200 to be absorbed by the first insulating layer 201, thereby preventing it from being transmitted to the second insulating layer 202 and/or the third insulating layer 203.

In addition, the width of the second insulating layer 202 of the connection member 200 in the horizontal direction can be different from the width of the third insulating layer 203 in the horizontal direction. The width of the second insulating layer 202 in the horizontal direction can be larger than the width of the third insulating layer 203 in the horizontal direction. At this time, the third insulating layer 203 can be a solder resist, and thus, cracks can easily occur due to external impact. In addition, a manufacturing process of the connection member 200 can include a sawing process. The above-described sawing process may be a process for individually separating a plurality of connection members. At this time, if an impact is applied to the third insulating layer 203 in the above-described sawing process, there is a problem that a crack occurs in the third insulating layer 203. Therefore, the embodiment makes it possible to protect the third insulating layer 203 from the impact by making the width of the third insulating layer 203 smaller than the widths of the first insulating layer 201 and the second insulating layer 202.

Specifically, a horizontal distance from a side end of the first insulating layer 201 of the connection member 200 to a side end of the third insulating layer 203 can satisfy a range of 50 µm to 70 µm. If the horizontal distance from the side end of the first insulating layer 201 of the connection member 200 to the side end of the third insulating layer 203 is less than 50 µm, an impact may be applied to the third insulating layer 203 during the sawing process, and thus a crack may occur in the third insulating layer 203. In addition, if the horizontal distance from the side end of the first insulating layer 201 of the connection member 200 to the side end of the third insulating layer 203 exceeds 70 µm, the circuit layer included in the connection member 200 may not be stably protected, or a region where the circuit layer is not disposed in the connection member 200 may increase, and thus the circuit integration may be reduced.

Accordingly, the side surfaces of the first insulating layer 201, the second insulating layer 202, and the third insulating layer 203 of the connection member 200 can have a step from each other. Through this, the step of the side surface of the connection member 200 can come into contact with the insulating layer of the circuit board, thereby increasing the contact area.

Meanwhile, the connection member 200 may be provided with a circuit pattern 204. The circuit pattern 204 may include a connection electrode 210 disposed at an uppermost side of the connection member 200.

At this time, an upper surface of the connection electrode 210 of the connection member 200 may be positioned lower than an upper surface of the third insulating layer 203 of the connection member 200. For example, the connection electrode 210 of the connection member 200 may include only a pad part. In addition, when the connection electrode 210 of the connection member 200 includes only a pad part, the third electrode part 140 may not horizontally overlap with the connection electrode 210. In another embodiment, the connection electrode 210 of the connection member 200 may further include a bump part disposed on the pad part. Through this, the connection electrode 210 of the connection member 200 can protrude from the upper surface of the connection member 200. At this time, the third electrode part 140 can be provided on the connection member 200. For example, the third electrode part 140 can be provided in a region that does not vertically overlap with the connection electrode 210 on the upper surface of the third insulating layer 203 of the connection member 200. In addition, when the connection electrode 210 of the connection member 200 includes a bump part, the third electrode part 140 can horizontally overlap with the connection electrode 210 of the connection member 200.

Referring to FIG. 12, each of the first protruding electrode 160A, the second protruding electrode 160B, and the second and third protruding electrodes 180 can include a plurality of metal layers.

For example, each of the first protruding electrode 160A and the second protruding electrode 160B may include a first metal layer 160-1 disposed on the first electrode part 130 and the second electrode part 135, respectively. In addition, each of the first protruding electrode 160A and the second protruding electrode 160B may include a second metal layer 160-2 disposed on the first metal layer 160-1. At this time, the first metal layer 160-1 and the second metal layer 160-2 may include different metal materials.

Preferably, the first metal layer 160-1 may include nickel. In addition, the second metal layer 160-2 may include copper. The first metal layer 160-1 can improve the bonding strength between the second metal layer 160-2 and the first electrode part 130 or the second electrode part 135. For example, when the second metal layer 160-2 is directly disposed on the first electrode part 130 or the second electrode part 135, oxidation of the first electrode part 130 or the second electrode part 135 may occur, which may reduce the bonding strength therebetween. Therefore, the first metal layer 160-1 can function to prevent oxidation of the first electrode part 130 or the second electrode part 135 while improving the bonding strength therebetween. In addition, the first metal layer 160-1 can solve the problem of the first protruding electrode 160A and the second protruding electrode 160B being peeled off from the first electrode part 130 or the second electrode part 135 due to contraction and expansion of the first protective layer 112 caused by thermal stress.

Specifically, when the first metal layer 160-1 includes nickel, the adhesion between the first electrode part 130 or the second electrode part 135 and the second metal layer 160-2 can be improved. In addition, when electrical connection is made with the first electrode part 130 or the second electrode part 135 later through a material such as solder, the solder may diffuse into the first electrode part 130 or the second electrode part 135 to form an inter-metallic compound, and the inter-metallic compound has a problem of deteriorating mechanical and electrical reliability. In particular, when the second metal layer 160-2 is made of copper, the problem of forming an inter-metallic compound may be further aggravated, but when nickel is disposed, the diffusion of solder can be prevented, thereby preventing the formation of the inter-metallic compound, thereby improving the electrical and mechanical reliability of the semiconductor package.

At this time, the first electrode part 130 and the second electrode part 135 may include a crevice 130C. For example, upper surfaces of the first electrode part 130 and the second electrode part 135 may include a crevice 130C that is concave toward the lower surface of the first electrode part 130 or the second electrode part 135 while vertically overlapping the first protruding electrode 160A and the second protruding electrode 160B. The crevice 130C may be filled with the first metal layer 160-1. Through this, a contact area between the first electrode part 130 or the second electrode part 135 and the first protruding electrode 160A and the second protruding electrode 160B can be increased, and thus the bonding strength can be further improved.

In addition, the third protruding electrode 180 may also include a first metal layer 180-1 and a second metal layer 180-2. The first metal layer 180-1 of the third protruding electrode 180 may be disposed on the fourth electrode part 150. In addition, the second metal layer 180-2 of the third protruding electrode 180 may be disposed on the first metal layer 180-1. A crevice 150C may be provided at an upper surface of the fourth electrode part 150, and the first metal layer 180-1 of the third protruding electrode 180 may be provided to fill the crevice 150C of the fourth electrode part 150.

Referring to FIG. 14, the third electrode part 140 may include a dummy through electrode 145 horizontally overlapping the first electrode part 130 and the second electrode part 135. The dummy through electrode 145 may improve the rigidity of the circuit board while preventing the circuit board from being greatly bent in a specific direction.

Referring to FIG. 15, the circuit board may further include a dummy protruding electrode 170 disposed on the dummy through electrode 145. The dummy protruding electrode 170 may be provided between the first protruding electrode 160A and the second protruding electrode 160B. In addition, the dummy protruding electrode 170 may improve the rigidity of the circuit board and transfer heat generated from the connection member 200 to an end potion of the circuit board. In addition, the dummy protruding electrode 170 may also function as a recognition unit that may recognize coupling positions of a plurality of semiconductor devices on the circuit board. For example, the embodiment may easily recognize the coupling positions of the first semiconductor device and the second semiconductor device based on the dummy protruding electrode 170 having a relatively large size, thereby allowing the first semiconductor device and the second semiconductor device to be stably coupled on the circuit board at an accurate position.

In addition, the dummy protruding electrode 170 may be provided between the first protruding electrode 160A and the second protruding electrode 160B. For example, the dummy protruding electrode 170 may be provided in a region corresponding to a separation distance between the first semiconductor device 310 and the second semiconductor device 320. Accordingly, at least a portion of the dummy protruding electrode 170 may not vertically overlap the first semiconductor device 310 and the second semiconductor device 320.

In addition, the dummy protruding electrode 170 may be provided as a single unit, or alternatively, may be provided as a plurality of units.

However, a plane area of the single electrode of the dummy protruding electrode 170 may be larger than a plane area of each of single electrodes of the first protruding electrode 160A, the second protruding electrode 160B, and the third protruding electrode 180. Through this, the embodiment can maximize the plane area of the dummy protruding electrode 170, thereby improving the rigidity of the semiconductor package. Furthermore, the dummy protruding electrode 170 can be in contact with a molding member 330. The molding member 330 may have a stronger adhesive force with a metal material than with an insulating material. Therefore, the embodiment can maximize the plane area of the dummy protruding electrode 170, thereby increasing the contact area with the molding member 330, and thereby further improving the adhesive force therebetween. In addition, the embodiment can further improve the heat dissipation characteristics for heat generated in the first semiconductor device 310, the second semiconductor device 320, and the connection member 200 by maximizing the plane area of the dummy protruding electrode 170.

Referring to FIG. 16, the connection member 200 can be disposed in a cavity provided in the first insulating part 110. At this time, the cavity can be provided in at least a part of layers of the first insulating part 110.

The circuit board 100 can further include an adhesive member 190 disposed on a bottom surface of the cavity. The adhesive member 190 can enable the connection member 200 to be firmly fixed to the cavity. The adhesive member 190 can have a different width from the connection member 200. In addition, the adhesive member 190 can have a width different from the width of the cavity.

For example, the width of the adhesive member 190 may be larger than the width of the connection member 200. This prevents the connection member 200 from being peeled off due to various impacts applied in the operating environment of the semiconductor package. For example, the adhesive member 190 may have a width larger than the connection member 200 in order to improve bonding strength with the connection member 200.

In addition, the adhesive member 190 may have a width smaller than the width of the cavity. For example, the adhesive member 190 may not contact a side wall of the cavity. Therefore, the embodiment can prevent the adhesive member 190 from contacting an inner wall of the cavity as the adhesive member 190 expands due to damage. Accordingly, the embodiment can minimize stress applied by expansion of the adhesive member 190.

The semiconductor package of the embodiment may include an insulating layer and a connection member embedded in the insulating layer. The connection member may include first and second connection electrodes. In addition, the semiconductor package may include a first electrode part and a second electrode part disposed in the insulating layer. The first electrode part may vertically overlap with a first connection electrode of the connection member. In addition, the second electrode part may vertically overlap with a second connection electrode of the connection member. In addition, the electrode part may further include a third electrode part provided between the first electrode part and the second electrode part or between the first connection electrode and the second connection electrode. The third electrode part may be electrically floated with the connection member and may physically contact the connection member. The third electrode part may be provided in a region of an upper surface of the connection member where the connection electrode is not provided. The third electrode part may improve adhesion between the insulating layer and the connection member.

Through this, the embodiment can increase an adhesion between the insulating layer and the connection member, thereby solving a problem of the connection member being peeled off from the insulating layer.

Furthermore, the embodiment can improve a rigidity of the connection member and/or a rigidity of the semiconductor package by using the third electrode part, thereby improving the mechanical reliability of the semiconductor package. Through this, the embodiment can solve a problem of the connection member and/or the semiconductor package being greatly bent in a specific direction. Through this, the embodiment can enable the semiconductor package to operate stably. In addition, the embodiment can enable an electronic product and/or server to which the semiconductor package is applied to operate smoothly.

In addition, a surface roughness value of the third electrode part can be greater than a surface roughness value of the connection electrode provided in the connection member. Through this, the embodiment can minimize a signal transmission loss that increases in proportion to the surface roughness value by making the connection electrode have a surface roughness value smaller than the surface roughness value of the third electrode part, thereby improving signal transmission characteristics of the semiconductor package. Furthermore, the embodiment can further improve the adhesion between the insulating layer and the connection member without affecting the signal transmission characteristics by increasing the surface roughness value of a dummy electrode.

Meanwhile, the dummy electrode in one embodiment can include only a dummy electrode pattern disposed on the connection member. The dummy electrode in another embodiment can include a dummy through electrode penetrating from an upper surface of the first insulating layer to a portion of the first insulating layer, together with the dummy electrode pattern. In another embodiment, the third electrode part can include a dummy through electrode and a dummy protruding electrode together with the dummy electrode pattern. In addition, when the third electrode part includes the dummy through electrode and the dummy protruding electrode, an adhesion between the connection member and the insulating layer can be further improved, while further improving the rigidity of the semiconductor package.

On the other hand, when the circuit board having the above-described characteristics of the invention is used in an IT device or home appliance such as a smart phone, a server computer, a TV, and the like, functions such as signal transmission or power supply can be stably performed. For example, when a circuit board having the features of the present invention performs a semiconductor package function, the circuit board can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
an insulating layer;
a connection member embedded in the insulating layer; and
an electrode part embedded in the insulating layer and overlapping the connection member in a vertical direction,
wherein the connection member includes an electrode pattern disposed on the connection member, and
wherein the electrode pattern is electrically floated with the electrode part.

2. The circuit board of claim 1, wherein the connection member includes first and second connection electrodes spaced apart from the electrode pattern in a horizontal direction,
wherein the electrode part includes a first electrode part overlapping the first connection electrode in the vertical direction; and a second electrode part overlapping the second connection electrode in the vertical direction; and
wherein the electrode pattern is electrically floated with the first electrode part, the second electrode part, the first connection electrode, and the second connection electrode.

3. The circuit board of claim 2, wherein the insulating layer includes a first insulating layer having a cavity; and a second insulating layer disposed on the first insulating layer and filling at least a portion of the cavity, and
wherein the connection member is disposed in the cavity,
wherein the first electrode part includes a first through electrode penetrating at least a portion of the second insulating layer and overlapping the first connection electrode in the vertical direction and a second through electrode penetrating at least a portion of the second insulating layer and overlapping the first connection electrode in the vertical direction, and
wherein the electrode pattern does not overlap the first and second through electrodes in the vertical direction.

4. The circuit board of claim 3, wherein the first electrode part includes a first wiring electrode disposed on the first through electrode and a second wiring electrode disposed on the second through electrode, and
wherein the electrode pattern does not overlap the first and second wiring electrodes in the vertical direction.

5. The circuit board of claim 2, wherein the electrode pattern is disposed on an upper surface of the connection member in a same plane as the first and second connection electrodes.

6. The circuit board of claim 2, wherein a surface roughness value of the electrode pattern is greater than a surface roughness value of at least one of the first and second connection electrodes.

7. The circuit board of claim 7, wherein each of the first and second connection electrodes is provided in a plurality of numbers, and
wherein a plane area of an single electrode pattern is greater than a plane area of a single electrode of each of the plurality of first and second connection electrodes.

8. The circuit board of claim 2, wherein edge shapes of upper surfaces of each of the first and second connection electrodes are identical to each other, and
wherein an edge shape of an upper surface of the electrode pattern is different from the edge shapes of the first and second connection electrodes.

9. The circuit board of claim 4, further comprising:
a dummy through electrode disposed on the electrode pattern and overlapping at least a portion of the first and second through electrodes in a horizontal direction, and
a dummy wiring electrode disposed on the dummy through electrode and overlapping the first and second wiring electrodes in the horizontal direction.

10. The circuit board of claim 9, further comprising:
a protective layer disposed on the insulating layer; and
a first protruding electrode penetrating at least a portion of the protective layer and overlapping the first wiring electrode in the vertical direction;
a second protruding electrode penetrating at least a portion of the protective layer and overlapping the second wiring electrode in the vertical direction; and
a dummy protruding electrode penetrating at least a portion of the protective layer and overlapping the dummy wiring electrode in the vertical direction.
